Europäisches Patentamt

European Patent Office

Office européen des brevets

(11) Publication number: **0 530 373 A1**

## EUROPEAN PATENT APPLICATION
### published in accordance with Art. 158(3) EPC

(21) Application number: 92906920.1

(22) Date of filing: 18.03.92

(86) International application number:
**PCT/JP92/00325**

(87) International publication number:
**WO 92/17000 (01.10.92 92/25)**

(51) Int. Cl.5: **H03K 19/0175**

(30) Priority: **20.03.91 JP 56886/91**

(43) Date of publication of application:
**10.03.93 Bulletin 93/10**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**
Applicant: **FUJITSU VLSI LIMITED**
**1844-2, Kozoji-cho 2-chome**
**Kasugai-shi Aichi 487(JP)**

(72) Inventor: **SEKI, Teruo**
**Fujitsu VLSI Limited 1844-2, Kozoji-cho**
**2-chome**
**Kasugai-shi Aichi 487(JP)**
Inventor: **UKAI, Hiroaki**
**Fujitsu VLSI Limited 1844-2, Kozoji-cho**
**2-chome**
**Kasugai-shi Aichi 487(JP)**

(74) Representative: **Billington, Lawrence Emlyn et al**
**Haseltine Lake & Co Hazlitt House 28,**
**Southampton Buildings Chancery Lane**
**London WC2A 1AT (GB)**

(54) **CIRCUIT FOR CONVERTING LEVEL.**

(57) A circuit for converting a first logical level into a second one. Even when the voltage of a power supply is increased, the low level of the output voltage of a switching circuit (25) is suppressed from increasing, and accordingly an output buffer (28) is always made operable, because voltage limiting elements (26, 27) suppress the output level shift voltages of level-shifting devices (21, 22) connected to the output ends of input transistors ($Q_1$, $Q_2$) to predetermined values.

Rank Xerox (UK) Business Services
(3.10/3.5x/3.0.1)

# FIG. 5

## FIELD OF THE INVENTION

The present invention relates to a level conversion circuit, and more particularly to a level conversion circuit for converting a first logic level to a second logic level.

Generally, a standard logic is established for a digital circuit element for circuit versatility. A signal level as per various logic standards is embodied by an emitter-coupled logic (ECL) level, a transistor-transistor logic (TTL) level, or a CMOS level, for example. Accordingly, a level conversion circuit is required as an interface circuit between different standard logics in order to enable a signal transmission using different kinds of standard logic.

## BACKGROUND ART

A conventional level-conversion circuit shifts an input signal having a first logic level, where a difference between the binary logic levels is set to be at a first value, to a new level by means of a pair of level shifting diodes after the first logic level signal passes through a pair of input transistors. The conversion circuit supplies the two resulting signals, whose levels are shifted, to a differential amplifier so that the signals are amplified to a different logic level, and then output from the amplifier.

However, the conventional level-conversion circuit of this configuration has disadvantages in that when the output signal is designed to have a CMOS level, a large current is needed to improve an operation speed. This is because the differential amplifiers are configured by MOS transistors. There is also a disadvantage in that power consumption of a differential amplifier is great.

Accordingly, the present applicant had proposed a level-conversion circuit as shown in FIG.1 in the Japanese Laid-Open Patent Application 2-15251. Referring to FIG.1, the level-conversion circuit comprises a level-shifting circuit 11, a switching circuit 12, and an output buffer 13. The level-shifting circuit 11 comprises npn-transistors $Q_1$ and $Q_2$, level-shifting diodes $D_{11}$, $D_{12}$, $D_{21}$, and $D_{22}$, and constant-current sources $CS_1$ and $CS_2$.

The switching circuit 12 comprises: p-channel MOS transistors $Q_{p1}$ and $Q_{p2}$, and n-channel MOS transistors $Q_{n1}$ and $Q_{n2}$, wherein the drains of the MOS transistors $Q_{p1}$ and $Q_{n1}$ are connected, and the drains of the MOS transistors $Q_{p2}$ and $Q_{n2}$ are connected. The output buffer 13 comprises a p-channel MOS transistor $Q_{p3}$ whose drain is connected to the drain of an inverter $I_{nv}$, and an n-channel MOS transistor $Q_{n3}$.

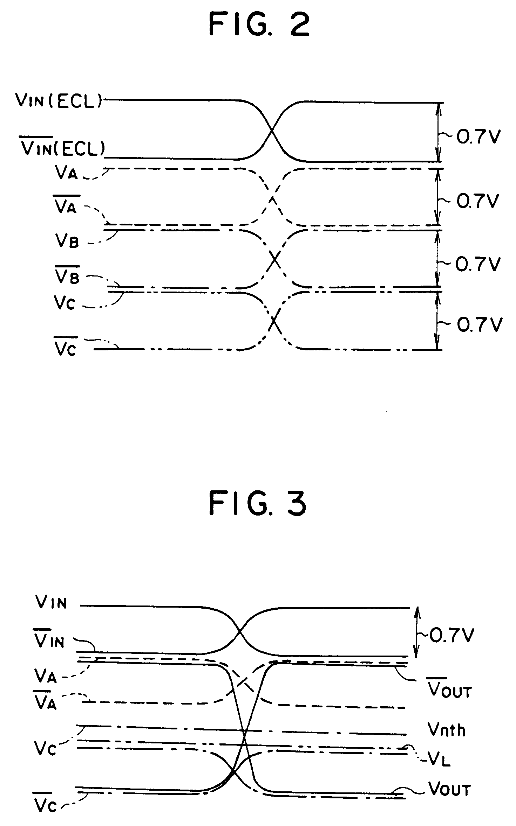

In this level-conversion circuit, an input signal having a first logic amplitude and being subjected to level conversion is reversed in polarity and the signals before and after the reversion are fed to the bases of the input transistors $Q_1$ and $Q_2$. Assuming that the first logical amplitude is of an ECL level, that is, that a difference between a high level and a low level is about 0.7V, an input voltage $V_{IN}$ shown in FIG.2 is fed to the input of the base of the transistor $Q_1$, and the input voltage $\overline{V}_{IN}$ shown in FIG.2 is fed to the input of the base of the transistor $Q_2$.

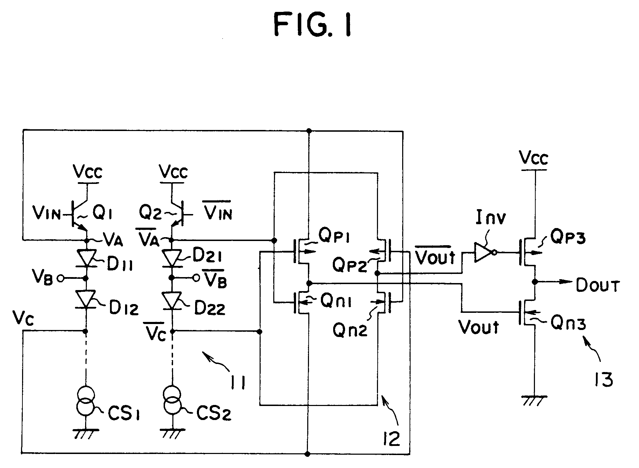

The levels of the input voltages $V_{IN}$ and $\overline{V}_{IN}$ are shifted to a lower level by a base-emitter potential $V_{BE}$ (0.75V, for example) of the input transistors $Q_1$ and $Q_2$, and are output, as the voltages $V_A$ and $\overline{V}_A$ shown in FIG.2, from the emitters of the transistors $Q_1$ and $Q_2$. The level of this voltage $V_A$ is shifted to a lower level, in steps, by a predetermined amount by means of the diodes $D_{11}$ and $D_{12}$ shown in FIG.1, so as to create voltages $V_B$ and $V_C$ as shown in FIG.2. In parallel with this, the level of the voltage $\overline{V}_A$ is shifted to a lower level, in steps, by a predetermined amount by means of the diodes $D_{21}$ and $D_{22}$ shown in FIG.1 so as to create voltages $\overline{V}_B$ and $\overline{V}_C$ shown in FIG.2.

The above-mentioned voltages $V_A$ and $V_C$ are supplied as the power-source voltages of the circuit portion consisting of MOS transistors $Q_{p1}$ and $Q_{n1}$, while being also supplied as the gate input voltages of the MOS transistors $Q_{n2}$ and $Q_{p2}$. The above-mentioned voltages $\overline{V}_A$ and $\overline{V}_C$, however, are supplied as the power-source voltages of the circuit portion consisting of the MOS transistors $Q_{p2}$ and $Q_{n2}$, while being also supplied as the gate input voltages of the MOS transistors $Q_{n1}$ and $Q_{p1}$.

In this way, a voltage, shown as $V_{OUT}$ in FIG.3, having an amplitude of $V_A$ - $\overline{V}_C$ (about 2V) is output from a common drain junction of the transistors $Q_{p1}$ and $Q_{n1}$. A voltage, shown as $\overline{V}_{OUT}$ in FIG.3, having a reversed polarity in relation to the above $V_{OUT}$, and having an amplitude of $\overline{V}_A$ - $V_C$ is output from a common drain junction of the transistors $Q_{p2}$ and $Q_{n2}$.

Once the voltages $V_{OUT}$ and $\overline{V}_{OUT}$, which are obtained by converting the input voltages $V_{IN}$ and $\overline{V}_{IN}$ into voltages having a larger amplitude, are output, $V_{OUT}$ is applied to the gate of the MOS transistor $Q_{n3}$, and $\overline{V}_{OUT}$ is applied to the gate of the MOS transistor $Q_{p3}$ via the inverter $I_{NV}$. In this way, an output voltage $D_{OUT}$ having an amplitude of about 5V, with a high level equal to the power source voltage $V_{CC}$ (5V, for example) and a low level equal to the ground potential, that is, a voltage having a CMOS level, is output from a common drain terminal of the MOS transistors $Q_{p3}$ and $Q_{n3}$.

In the above level-conversion circuit proposed by the present applicant, power consumption is suppressed in static conditions as compared with the above-described conventional level conversion circuit; this is because one of the transistors $Q_{p1}$ and $Q_{n1}$ and one of the transistors $Q_{p2}$ and $Q_{n2}$ are ensured to be turned off. Also, a rapid level conversion is possible by virtue of a switching operation of the switching circuit 12.

Since the above level-conversion circuit proposed by the present applicant uses the constant current sources $CS_1$ and $CS_2$ in the level-shifting circuit 11, the output voltages $V_A$, $\overline{V}_A$, $V_C$, and $\overline{V}_C$ of the level-shifting circuit 11 rise, to a higher level while maintaining the same amplitude; this occurs when the power source voltage $V_{CC}$ rises to a level higher than a predetermined value due to a system failure, for example.

Consequently, the output voltages $V_{OUT}$ and $\overline{V}_{OUT}$ of the switching circuit 12 rise, and, in extreme cases, the low level of the output voltage $\overline{V}_{OUT}$ becomes higher than a threshold voltage (shown as $V_{nth}$ in FIG.3) of the transistor $Q_{n3}$ of the output buffer 13, and the low level of the output voltage $V_{OUT}$ becomes higher than a threshold voltage (the same as $V_{nth}$ in FIG.3) of the inverter $I_{nv}$ of the output buffer 13.

In these cases, the transistor $Q_{n3}$ is always turned on; the output voltage of the inverter $I_{nv}$ is always at a low level; and thus the transistor $Q_{p3}$ is always turned on. Consequently, the buffer 13 of the above level-conversion circuit proposed by the present applicant may become inoperable due to a rise of the power-source voltage $V_{CC}$.

Accordingly, an object of the present invention is to provide a level-conversion circuit, wherein a rise of the low level is prevented even under a rise of the power source voltage.

Another object of the present invention is to provide a level-conversion circuit for converting an input signal having an ECL level or a TTL level to a signal having a CMOS level.

DISCLOSURE OF THE INVENTION

In order to achieve the above object, the level-conversion circuit of the present invention is characterized by comprising:

first and second transistors receiving, respectively, inputs of first and second input signals that have a first binary logic level and have reversed polarities in relation to each other;

first and second level-shifting elements connected to output terminals of the first and second input transistors, and each having a plurality of output terminals;

first and second constant current sources disposed between a) the first and second level-shifting elements and b) a low-potential power source;

a switching circuit supplied with first and second level-shifted voltages output from two output terminals of the first level-shifting element, respectively, from among the plurality of output terminals of the first level-shifting element, and supplied with a third and fourth level-shifted voltages output from two output terminals of the second level-shifting element, respectively, from among the plurality of output terminals of the second level-shifting element, wherein a voltage is output as an output voltage in response to a difference either between the third and fourth level-shifted voltages or between the first and second level-shifted voltages;

first and second voltage limiting elements disposed between output terminals of the first and second level-shifting elements, from which terminals the second and fourth level-shifted voltages are output, and the low-potential power source; and

an output buffer for converting an output voltage of the switching circuit into a signal having a second binary logic level and outputting the converted signal.

According to the present invention, a rise in the second and fourth level-shifted voltages output from the first and second level-shifting elements 21 and 22 can be limited to a predetermined voltage even under a rise of a power-source voltage. It is thus ensured in the present invention that the output buffer always operates normally even under a rise in the power-source voltage.

Alternatively, the output buffer of the present invention can comprise: a third n-channel MOS transistor whose gate is connected to a common junction between drains of said p-channel MOS transistor and said first n-channel MOS transistor, the two transistors constituting one push-pull circuit in the switching circuit, and whose source is connected to the low-potential power source; an inverter whose input terminal is connected to a common drain junction between drains of said second p-channel MOS transistor and said second n-channel MOS transistor, the two transistors constituting the other push-pull circuit in the switching circuit; and a third p-channel MOS transistor the gate thereof being connected to an output terminal of said inverter, the source thereof being connected to a high-potential power source, and the drain thereof being connected to a drain of said n-channel MOS transistor.

It is ensured in this way that a mutual phase-error is avoided, the error occurring when two output voltages output from the switching circuit are opposite in polarity. Further, the present invention enables the conversion of the ECL logic level or the TTL logic level into the CMOS logic level.

BRIEF DESCRIPTION OF THE DRAWINGS

FIG.1 is a circuit diagram of an example of a level-conversion circuit that the present applicant has previously proposed;

FIG.2 shows waveform illustrations for each portion of the circuit of FIG.1;

FIG.3 shows threshold values and waveform illustrations for an essential portion of the circuit of FIG.1;

FIG.4 is a diagram illustrating the principle and the configuration of the present invention;

FIG.5 is a circuit diagram of an embodiment of the present invention;

FIG.6 is a circuit diagram illustrating an example of a source of an input signal fed to the input of the circuit of the present invention;

FIG.7 is a circuit diagram illustrating another example of a source of an input signal fed to the input of the circuit of the present invention;

FIG.8 is a circuit diagram illustrating a variation of the essential portion of the present invention.

## BEST MODE OF CARRYING OUT THE INVENTION

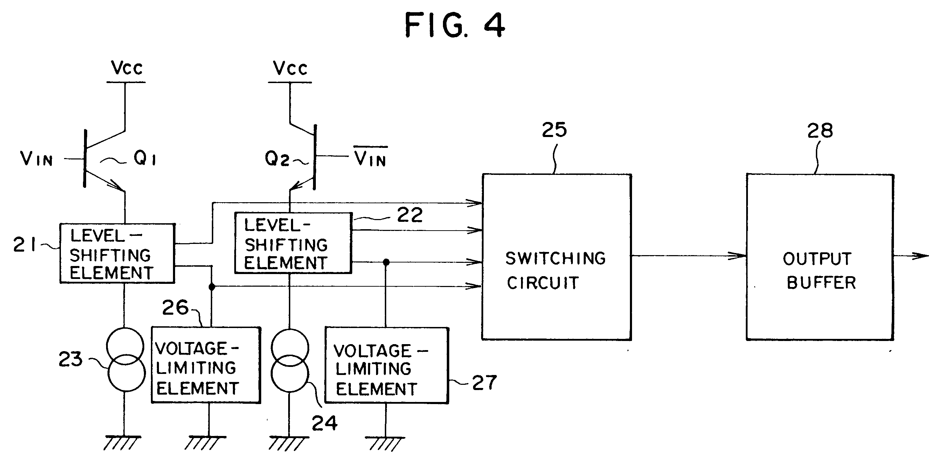

In FIG.4, which illustrates the principle and the configuration of the present invention, a first input signal $V_{IN}$ and a second input signal $\overline{V}_{IN}$ of opposite polarities, both signals having a first binary logic level, are fed to the input transistors $Q_1$ and $Q_2$. These input signals $V_{IN}$ and $\overline{V}_{IN}$ are output from the emitters of the input transistors $Q_1$ and $Q_2$ respectively, and are separately subjected to a level shifting by level-shifting elements 21 and 22.

A switching circuit 25 is supplied with first and second level-shifted voltages output from two output terminals, which are among a plurality of output terminals of the first level-shifting element 21, and with third and fourth level-shifted voltages output from two output terminals, which terminals are among a plurality of output terminals of the second level-shifting element 22; the switching circuit then generates a voltage in correspondence with a difference between the third and fourth level-shifted voltages (or a difference between the first and second level-shifted voltages).

Voltage limiting elements 26 and 27 are provided between an output terminal of each of the first and second level-shifting elements 21 and 22, from which terminals are output the second and fourth level-shifted voltages, and a low-potential power source. In this way, a rise of the second level-shifted voltage is limited by the first voltage limiting element 26, and a rise of the fourth level-shifted voltage is limited by the second voltage limiting element 27.

An output buffer 28 converts an output voltage from the switching circuit 25 into a signal having a second binary logic level and outputs the result of this conversion. Since, in this invention, the above-mentioned second and fourth level-shifted voltages are controlled to be below a predetermined value, a rise of the low level of the output voltage from the switching circuit 25 is limited even under an increase of the power source voltage. Therefore, the buffer 28 operates normally even under an increase of the power source voltage.

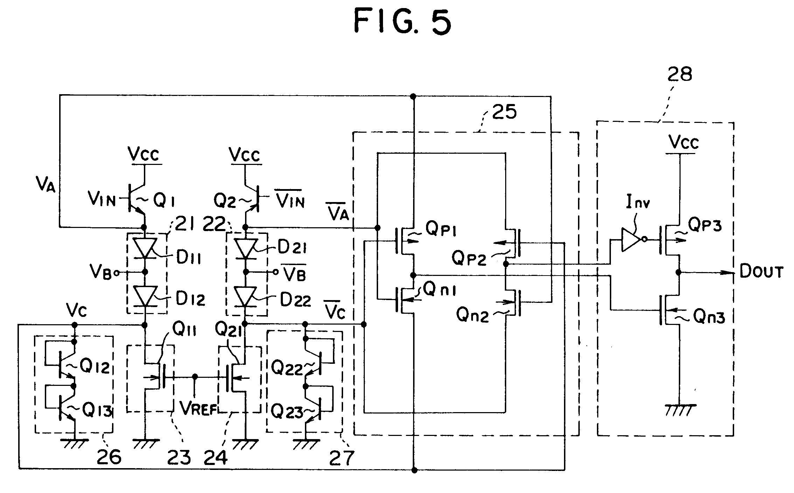

A description will be given next of the circuit configuration and the operation of an embodiment of the present invention. FIG.5 is a circuit diagram of an embodiment of the present invention. In the Figure, components that are the same as components in FIGS.1 and 4 are given the same reference notations from figure to figure. In FIG.5, the input transistors $Q_1$ and $Q_2$ are npn-transistors, the emitters thereof being connected to the anodes of the diodes $D_{11}$ and $D_{21}$.

The cathode of the diode $D_{11}$ is connected to the anode of the diode $D_{12}$, the diodes $D_{11}$ and $D_{12}$ together forming the level-shifting element 21. The level-shifted voltages $V_A$ and $V_B$ are output from the anode and cathode of the diode $D_{11}$; and the level-shifted voltage $V_C$ is output from the cathode of the diode $D_{12}$. The level-shifted voltages $V_A$ and $V_C$ correspond to the aforementioned first and second level-shifted voltages.

On the other hand, the cathode of the diode $D_{21}$ is connected to the anode of the diode $D_{22}$, the diodes $D_{21}$ and $D_{22}$ together forming the level-shifting element 22. The level-shifted voltages $\overline{V}_A$ and $\overline{V}_B$ are respectively output from the anode and from the cathode of the diode $D_{21}$; and the level-shifted voltage $V_C$ is output from the cathode of the diode $D_{22}$. The level-shifted voltages $\overline{V}_A$ and $\overline{V}_C$ correspond to the aforementioned third and fourth level-shifted voltages.

The n-channel MOS transistors $Q_{11}$ and $Q_{21}$ constitute constant current sources 23 and 24 in such a way that the drains thereof are connected to the cathodes of the diodes $D_{12}$ and $D_{22}$, while the sources thereof are connected to the ground, which ground serves as a low-potential power source, and a constant voltage $V_{REF}$ is applied to the gates of the n-channel MOS transistors $Q_{11}$ and $Q_{21}$.

The base and the collector of the npn-transistors $Q_{12}$ and $Q_{13}$ are connected to each other (that is, provided with a diode junction); the base and the collector of the transistor $Q_{12}$ are connected to the junction between the diode $D_{12}$ and the drain of the MOS transistor $Q_{11}$; and the emitter of the transistor $Q_{12}$ is connected to the base and the collector of the transistor $Q_{13}$. The emitter of the transistor $Q_{12}$ is grounded. In this way, the transistors $Q_{12}$ and $Q_{13}$ constitute the aforementioned first voltage-limiting element 26.

Similarly, two diode-junctioned npn-transistors $Q_{22}$ and $Q_{23}$, which are provided between the ground and the common junction between the cathode of the diode $D_{22}$ and the drain of the MOS transistor $Q_{21}$, constitute the aforementioned sec-

ond voltage-limiting element 27. Diode-junctioned unipolar transistors, such as MOS transistors, may be used in place of the npn-transistors $Q_{12}$, $Q_{13}$, $Q_{22}$, and $Q_{23}$.

The p-channel MOS transistor $Q_{p1}$ and the n-channel MOS transistor $Q_{n1}$ constitute a first push-pull circuit, while at the same time constituting, together with the p-channel MOS transistor $Q_{p2}$ and the n-channel MOS transistor $Q_{n2}$, the aforementioned switching circuit 25. The p-channel MOS transistor $Q_{p2}$ and the n-channel MOS transistor $Q_{n2}$ constitute a second push-pull circuit.

The drain of the MOS transistor $Q_{p1}$ and the gate of the MOS transistor $Q_{n2}$ are connected to the anode of the diode $D_{11}$; and the drain of the MOS transistor $Q_{n1}$ and the gate of the MOS transistor $Q_{p2}$ are connected to the cathode of the diode $D_{12}$. The drain of the MOS transistor $Q_{p2}$ and the gate of the MOS transistor $Q_{n1}$ are connected to the anode of the diode $D_{21}$; and the drain of the MOS transistor $Q_{n2}$ and the gate of the MOS transistor $Q_{p1}$ are connected to the cathode of the diode $D_{22}$.

The p-channel MOS transistor $Q_{p3}$ and the n-channel MOS transistor $Q_{n3}$, the drains of the two transistors being connected to each other, each constitute a CMOS inverter, which inverter constitutes, together with the inverter $I_{nv}$, the aforementioned output buffer 28. The common junction between the MOS transistors $Q_{p2}$ and $Q_{n2}$ is connected to the gate of the MOS transistor $Q_{p3}$ via the inverter $I_{nv}$. The common junction between the MOS transistors $Q_{p1}$ and $Q_{n1}$ is connected to the gate of the MOS transistor $Q_{n3}$. The high-potential power source voltage $V_{CC}$ is applied to the source of the MOS transistor $Q_{p3}$; and the source of the MOS transistor $Q_{n3}$ is connected to the ground, which ground serves as the low-potential power source.

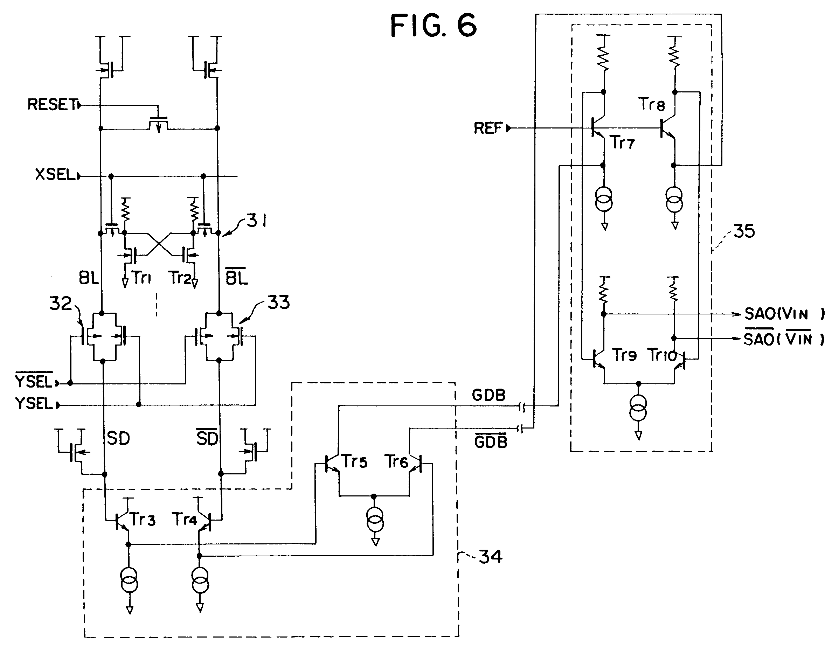

An example of the level-conversion circuit of this embodiment using the above configuration is shown in FIG.6, where a read signal, having an ECL level, of a Bi-CMOS static random access memory (SRAM) is supplied to the base of the input transistors $Q_1$ and $Q_2$. In FIG.6, a memory cell 31 is selected by an X address input signal input into an address line XSEL and by a Y address input signal input into address lines YSEL and $\overline{YSEL}$. Transfer gates 32 and 33 are subject to a switching control by a Y address signal.

Assuming that the memory cell 31 is selected, a signal value "1" is fed to a MOS transistor $T_{r1}$ and thus "1" is written in the memory cell 31 and a signal value "0" is fed to a MOS transistor $T_{r2}$; a high-level signal is fed to the input of the base of a npn-transistor $T_{r3}$ via a bit line BL, the transfer gate 32, and the data line SD; and a low-level signal is fed to the input of the base of a npn-transistor $T_{r4}$ via a bit line $\overline{BL}$, the transfer gate 33, and the data line $\overline{SD}$.

In this way, it is ensured that a current flowing through the transistor $T_{r3}$ is greater than a current flowing through the transistor $T_{r4}$ and that the base current of a npn-transistor $T_{r5}$ is greater than the base current of a npn-transistor $T_{r6}$. The transistors $T_{r3}$ - $T_{r6}$ constitute one amplifier portion 34; the other amplifier portion 35 resides on a remote position on the same semiconductor chip, the two amplifier portions being connected by signal lines GDB and $\overline{GDB}$.

With such a long wiring length, a large-amplitude voltage driving, using a CMOS level, for example, may cause deformed waveforms and a great propagation delay. Accordingly, it is normally practiced that an ECL-level signal, having a small amplitude, is transmitted for a current driving, so that propagation delay due to wiring capacitance is reduced.

In order to resolve the above objective, the transistors $T_{r5}$ and $T_{r6}$ carry out, at an ECL level, a current driving of the npn-transistors $T_{r7}$ and $T_{r8}$ in the amplifier portion 35, the two pairs of transistors being connected via the signal lines GDB and $\overline{GDB}$. That is, since the transistor $T_{r5}$ conducts more current than the transistor $T_{r6}$, the transistor $T_{r7}$ conducts more current than the transistor $T_{r8}$, the collector potential of the transistor $T_{r7}$ becomes lower than the collector potential of the transistor $T_{r8}$ due to a voltage drop caused by a collector load resistance.

Therefore, the collector current of a transistor $T_{r9}$, which transistor is one of a pair of npn-transistors $T_{r9}$ and $T_{r10}$, becomes small, while the collector current of the transistor $T_{r10}$ becomes large, with the result that the collector potential of the transistor $T_{r9}$ can be designated as a high level, and the collector potential of the transistor $T_{r10}$ can be designated as a low level. The collector potential of the transistor $T_{r9}$, which potential has a high level as defined in the ECL level configuration, is applied, as the aforementioned input voltage $V_{IN}$, to the base of the input transistor $Q_1$ shown in FIG.5. The collector potential of the transistor $T_{r10}$, which potential has a low level as defined in the ECL level configuration, is applied, as the aforementioned input voltage $\overline{V}_{IN}$, to the base of the input transistor $Q_2$.

It results from the above that, referring to FIG.5, the input voltage $V_{IN}$ is dropped, from a high level as defined in the ECL level configuration, to a lower level by an amount corresponding to the base-emitter voltage $V_{BE}$ (about 0.7V, for example) of the input transistor $Q_1$, and is output, as the voltage $V_A$, from the emitter of the transistor $Q_1$, $V_A$ being further subjected to a level shifting to a lower level by an amount corresponding to $2V_{DF}$ ($V_{DF}$

being a forward voltage of about 0.7V, for example, of a diode) by means of the diodes $D_{11}$ and $D_{12}$, thereby being output as the voltage $V_C$. Similarly, the input voltage $\overline{V}_{IN}$ is dropped, from a low level as defined in the ECL level configuration, to a lower level by an amount corresponding to the base-emitter voltage $V_{BE}$ and is output, as the voltage $\overline{V}_A$, $\overline{V}_A$ being further subjected to a level shifting to a lower level by an amount corresponding to $2V_{DF}$ by means of the diodes $D_{21}$ and $D_{22}$, thereby being output, as the voltage $\overline{V}_C$, from the cathode of the diode $D_{22}$.

The low-level voltage $\overline{V}_C$ is applied to the gate of the MOS transistor $Q_{p1}$, which is turned on by being supplied with a high-potential voltage $V_A$ as a power source, while the MOS transistor $Q_{n1}$ is turned off because the gate-source potential difference $(\overline{V}_A - V_C)$ is small. Therefore, a high-level voltage approximately equal to the voltage $V_A$ is applied to the gate of the MOS transistor $Q_{n3}$ so as to turn the transistor $Q_{n3}$ on.

The source-gate potential difference $(\overline{V}_A - V_C)$ of the MOS transistor $Q_{p2}$ is smaller than the threshold value because $\overline{V}_A$ has a low level, and $V_C$ has a high level $(\overline{V}_A > V_C)$, with the result that $Q_{p2}$ is turned off. Since the gate-source potential difference $(V_A - \overline{V}_C)$ of the MOS transistor $Q_{n2}$ is greater than the threshold value, $Q_{n2}$ is turned on. Thereby, the low-level voltage $\overline{V}_C$ is output from the common junction between the MOS transistors $Q_{p2}$ and $Q_{n2}$, the same voltage being reversed in polarity by the inverter $I_{nv}$ to become a high level voltage before being applied to the gate of the MOS transistor $Q_{p3}$, with the result that the MOS transistor $Q_{p3}$ is turned off.

Accordingly, a ground level signal, that is, the signal $D_{OUT}$, a low-level signal as defined in the CMOS level configuration, is output from the junction between the drains of the MOS transistors $Q_{p3}$ and $Q_{n3}$.

Contrary to the above operations, when the input voltage $V_{IN}$ has a low level as defined in the ECL level configuration, and the input voltage $\overline{V}_{IN}$ has a high level as defined in the ECL level configuration, the MOS transistor $Q_{p1}$ is off, the transistor $Q_{n1}$ is on, the transistor $Q_{p2}$ is on, and the transistor $Q_{n2}$ is off, so that the low-level voltage $V_C$ is applied to the gate of the MOS transistor $Q_{n3}$, and the high-level voltage $\overline{V}_A$ is applied to the inverter $I_{nv}$.

Accordingly, the MOS transistor $Q_{p3}$ is on; the transistor $Q_{n3}$ is off; and a voltage (5V in this case) of approximately the same value as the high-potential power source voltage $V_{CC}$ (that is, the high-level signal $D_{OUT}$ as defined in the CMOS level configuration) is output from the junction between the drains of $Q_{p3}$ and $Q_{n3}$. This is how the input voltages $V_{IN}$ and $\overline{V}_{IN}$ having an ECL level undergo a level conversion and yield the voltage $D_{OUT}$ having a CMOS level amplitude of about 5V, which voltage is output from the output buffer 28.

While the foregoing description assumes that the power source voltage $V_{CC}$ is normal, a description will be given below of the operation when, for some reason, the power source voltage $V_{CC}$ exhibits an abnormal rise. In this case, as the power source voltage $V_{CC}$ rises, each of the voltages $V_A$, $V_B$, $V_C$, $\overline{V}_A$, $\overline{V}_B$, and $\overline{V}_C$ rises.

However, a rise in the voltages $V_C$ and $\overline{V}_C$ are prevented in the following manner; that is, a current flows through the transistors $Q_{12}$ and $Q_{13}$, and through the transistors $Q_{22}$ and $Q_{23}$ so that the voltage $V_C$ cannot rise beyond the sum voltage $V_L$ (about 1.6V, for example) obtained by adding the base-emitter voltages of the transistors $Q_{12}$ and $Q_{13}$; and the voltage $\overline{V}_C$ cannot rise beyond the sum voltage $V_L$ (about 1.6V, for example) obtained by adding the base-emitter voltages of the transistors $Q_{22}$ and $Q_{23}$.

As shown in FIG.3, the above-mentioned sum voltage $V_L$ (about 1.6V, for example) is set to be of a value smaller than either the aforementioned threshold voltage $V_{nth}$ of the MOS transistor $Q_{n3}$ or the threshold value of the inverter $I_{nv}$, also controlled to be the same as $V_{nth}$. Therefore, even under an abnormal rise in the power source voltage $V_{CC}$, a rise in the voltages $V_C$ or $\overline{V}_C$ are always limited to be below the above-mentioned sum voltage $V_L$. As a result, the low levels of the output voltages $V_{OUT}$ and $\overline{V}_{OUT}$ are also limited to remain below the above-mentioned value $V_L$, so that the MOS transistor $Q_{n3}$ is ensured to be off by virtue of a low-level output of the switching circuit 25; and the inverter $I_{nv}$ reverses the low-level output of the switching circuit 25 to a high-level so as to turn off the MOS transistor $Q_{p3}$.

Even when the voltages $V_A$ and $\overline{V}_A$ rise in response to a rise of the power source voltage $V_{CC}$, operations for turning on the MOS transistors $Q_{p3}$ and $Q_{n3}$ are carried out in a normal manner.

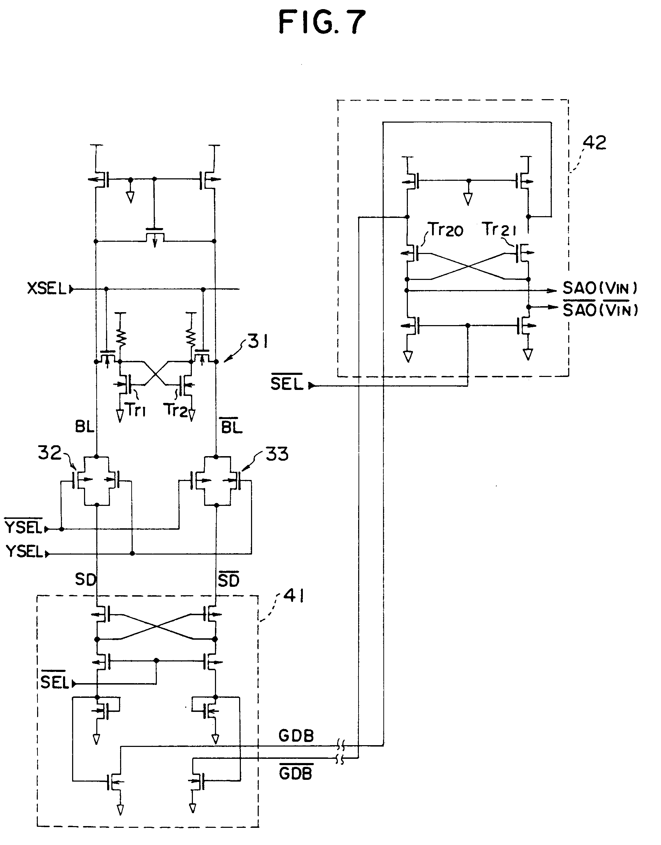

A read signal of a SRAM, of a configuration shown in FIG.7, is usable as a source for generating the input voltages $V_{IN}$ and $\overline{V}_{IN}$. In the figure, parts that are the same as those in FIG.6 are given the same reference notations as in FIG.6, and the description thereof is omitted. Referring to FIG.7, amplifier portions 41 and 42 are connected to each other via the signal lines GDB and $\overline{GDB}$.

Supposing that the amplifier portions 41 and 42 are configured by MOS transistors, a signal value "1" is fed to the transistor $T_{r1}$ and is thus written in the memory cell 31, a signal value "0" is fed to the transistor $T_{r2}$, and a current supplied to the bit line BL is $I + i$, then a current $i$ flows through $T_{r2}$ because $T_{r2}$ is turned on. Therefore, a current flowing through the line SD is $I + i$; and a current flowing through the line $\overline{SD}$ is I. The current (I + i) flows from the amplifier portion 42 to the amplifier portion 41 via the signal line GDB; and the current I flows in the same channel via the signal line $\overline{GDB}$. Consequently, a transistor $T_{r20}$, which is one of a pair of MOS transistors $T_{r20}$ and $T_{r21}$ in the amplifier portion 42, conducts a greater current than does the transistor $T_{r21}$, an output voltage SAO ($V_{IN}$) has a high level as defined in the ECL level configuration, and an output voltage $\overline{SAO}$ ($V_{IN}$) has a low level as defined in the ECL level configuration.

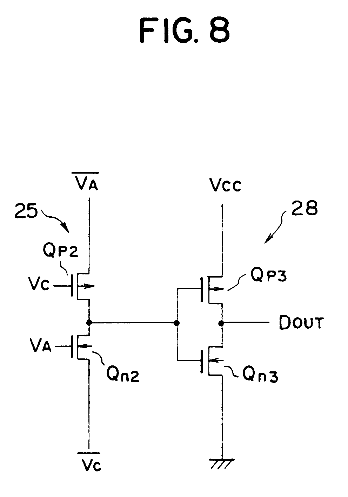

The present invention is not limited to the above embodiments. For example, the switching circuit 25 can be a single push-pull circuit consisting of the MOS transistors $Q_{p2}$ and $Q_{n2}$, as shown in FIG.8. In this variation, the common junction between the MOS transistors $Q_{p2}$ and $Q_{n2}$ is connected to the gates of the MOS transistors $Q_{p3}$ and $Q_{n3}$ constituting the output buffer 28.

The above arrangement ensures that $Q_{p2}$ is off and $Q_{n2}$ is on when the input voltage $V_{IN}$ has a high level, and the output voltage $D_{OUT}$ has a high level ($\fallingdotseq V_{CC}$) as defined in the CMOS level configuration. On the other hand, when the input voltage $V_{IN}$ has a low level, $Q_{p2}$ is on and $Q_{n2}$ is off, the high-level voltage $\overline{V}_A$ is supplied to the gates of the MOS transistors $Q_{p3}$ and $Q_{n3}$, turning on the MOS transistor $Q_{n3}$, with the result that the output voltage $D_{OUT}$ has a low level ($\fallingdotseq 0V$) as defined in the CMOS level configuration.

While it is assumed in the above embodiment that the input voltages $V_{IN}$ and $\overline{V}_{IN}$ have an ECL-level amplitude of about 0.7V, the present invention can also convert a TTL level having an amplitude of about 1.5V into a CMOS level. Further, the level shifting elements 26 and 27 can be configured by ordinary diodes or by constant-voltage elements such as Zener diodes. Another alternative is that a mixture of bipolar transistors having a diode junction, and unipolar transistors having a diode junction, are put into a continuous junction.

Further, although in the above embodiment a unit of two transistors, namely $D_{11}$ and $D_{12}$, and $D_{21}$ and $D_{22}$ are connected in series, it is also practicable that a unit of three transistors be connected in series. It is, of course, possible to set the number of diodes in the level-shifting elements 26 and 27 in accordance with the output voltage.

## POSSIBLE APPLICATION IN THE INDUSTRY

As has been described, since the level-conversion circuit of the present invention converts the ECL level and TTL level into the CMOS level, it is suitable for application in an interface circuit for feeding an ECL-level signal or a TTL-level signal to the input of a circuit operating on a CMOS level logic.

## Claims

1. A level-conversion circuit characterized by comprising:

first and second transistors ($Q_1$, $Q_2$) receiving, respectively, inputs of first and second input signals ($V_{IN}$, $\overline{V}_{IN}$) that are at a first binary logic level and have reversed polarities in relation to each other;

first and second level-shifting elements (21, 22) connected to output terminals of said first and second input transistors ($Q_1$, $Q_2$), each level-shifting element having a plurality of output terminals;

first and second constant current sources (23, 24) disposed between said first and said second level-shifting elements (21, 22) and a low-potential power source;

a switching circuit (25) supplied with first and second level-shifted voltages respectively output from two output terminals, from among the plurality thereof, of said first level-shifting element (21), and with third and fourth level-shifted voltages respectively output from two output terminals from among the plurality thereof of said second level-shifting element (22), of the second level-shifting element (22), wherein a voltage is output in response to a difference between either said third and fourth level-shifted voltages or between said first and second level-shifted voltages;

first and second voltage-limiting elements (26, 27) each disposed between a corresponding output terminal of said first and second level-shifting elements (21, 22), from which terminals said second and fourth level-shifted voltages are output, and said low-potential power source; and

an output buffer (28) for converting an output voltage of said switching circuit (25) into a signal having a second binary logic level, and outputting the converted signal.

2. The level conversion circuit as claimed in Claim 1, wherein each of said first and second voltage-limiting elements (26, 27) is configured by a plurality of diode-junctioned transistors ($Q_{12}$, $Q_{13}$, $Q_{22}$, and $Q_{23}$) that are connected in series so as to limit by a predetermined value a rise in said second and fourth level-shifted voltages.

3. The level-conversion circuit as claimed in Claim 2, wherein said diode-junctioned transistors are bipolar transistors ($Q_{12}$, $Q_{13}$, $Q_{22}$, and $Q_{23}$).

4. The level-conversion circuit as claimed in Claim 2, wherein said diode-junctioned transistors are unipolar transistors.

5. The level-conversion circuit as claimed in Claim 1, wherein said output buffer (28) is a CMOS inverter ($I_{nv}$, $Q_{p3}$, and $Q_{n3}$).

6. The level-conversion circuit as claimed in Claim 1, wherein said switching circuit (25) consists of a p-channel MOS transistor ($Q_{p1}$) whose source is supplied with said first level-shifted voltage as a high-potential power-source voltage, and whose gate is supplied with said fourth level-shifted voltage, and of an n-channel MOS transistor ($Q_{n1}$) whose source is supplied with said second level-shifted voltage as a low-potential power source voltage, and whose gate is supplied with said third level-shifted voltage, said level-conversion circuit being configured by a single push-pull circuit in which an output voltage is output from a common junction between drains of said p-channel MOS transistor ($Q_{p1}$) and an n-channel MOS transistor ($Q_{n1}$).

7. The level-conversion circuit as claimed in Claim 1, wherein:

said switching circuit (25) consists of the first and second p-channel MOS transistors ($Q_{p1}$, $Q_{p2}$), whose sources are supplied with said first and third level-shifted voltages as high-potential power-source voltages and whose gates are supplied with said fourth and second level-shifted voltages, which switching circuit 25 consists also of first and second n-channel MOS transistors ($Q_{n1}$, $Q_{n2}$) whose sources are supplied with said second and fourth level-shifted voltages as low-potential power-source voltages and whose gates are supplied with said third and first level-shifted voltages; and wherein

said level-conversion circuit consists of two push-pull circuits in which output voltages are output from a common junction between drains of said first p-channel MOS transistor ($Q_{p1}$) and said first n-channel MOS transistor ($Q_{n1}$) and from a common junction between drains of said second p-channel MOS transistor ($Q_{p2}$) and second n-channel MOS transistor ($Q_{n2}$).

8. The level-conversion circuit as claimed in Claim 7, wherein said output buffer (28) comprises: a third n-channel MOS transistor ($Q_{n3}$) whose gate is connected to a common junction between drains of said first p-channel MOS transistor ($Q_{p1}$) and said first n-channel MOS

transistor ($Q_{n1}$) and whose source is connected to said low-potential power source; an inverter ($I_{nv}$) whose input terminal is connected to a common junction between drains of said second p-channel MOS transistor ($Q_{p2}$) and said second n-channel MOS transistor ($Q_{n2}$); and a third p-channel MOS transistor ($Q_{p3}$) whose gate is connected to an output terminal of said inverter ($I_{nv}$), whose source is connected to a high-potential power source, and whose drain is connected to a drain of said n-channel MOS transistor ($Q_{n3}$).

9. The level-conversion circuit as claimed in Claim 1, wherein said first and second input signals ($V_{IN}$, $\overline{V}_{IN}$) have the ECL level or the TTL level, and a signal, having said second binary logic level, from said output buffer (28) has the CMOS level.

# FIG. 1

# FIG. 2

$V_{IN}$(ECL)

$\overline{V_{IN}}$(ECL)

~0.7V

$V_A$

$\overline{V_A}$

~0.7V

$V_B$

$\overline{V_B}$

~0.7V

$V_C$

~0.7V

$\overline{V_C}$

# FIG. 3

$V_{IN}$

$\overline{V_{IN}}$

~0.7V

$V_A$

$\overline{V_{OUT}}$

$\overline{V_A}$

$V_{nth}$

$V_C$

~$V_L$

~$V_{OUT}$

$\overline{V_C}$

11

# FIG. 4

EP 0 530 373 A1

# FIG. 5

EP 0 530 373 A1

# FIG. 6

EP 0 530 373 A1

# FIG. 7

# FIG. 8

# INTERNATIONAL SEARCH REPORT

International Application No    PCT/JP92/00325

**I. CLASSIFICATION OF SUBJECT MATTER** (if several classification symbols apply, indicate all) ⁶

According to International Patent Classification (IPC) or to both National Classification and IPC

Int. Cl⁵    H03K19/0175

**II. FIELDS SEARCHED**

Minimum Documentation Searched ⁷

| Classification System | Classification Symbols |
|---|---|
| IPC | H03K19/0175, 19/018, 19/0185 |

Documentation Searched other than Minimum Documentation
to the Extent that such Documents are Included in the Fields Searched ⁸

| | |
|---|---|
| Jitsuyo Shinan Koho | 1974 – 1991 |
| Kokai Jitsuyo Shinan Koho | 1975 – 1991 |

**III. DOCUMENTS CONSIDERED TO BE RELEVANT** ⁹

| Category * | Citation of Document, ¹¹ with indication, where appropriate, of the relevant passages ¹² | Relevant to Claim No. ¹³ |
|---|---|---|
| A | JP, A, 61-19226 (Hitachi, Ltd.), January 28, 1986 (28. 01. 86), Fig. 16 & US, A, 4,697,109 | 1, 5, 9 |
| A | JP, A, 2-280523 (NEC Corp.), November 16, 1990 (16. 11. 90), Fig. 1 (Family: none) | 1, 9 |
| P | JP, A, 3-220817 (Fujitsu Ltd. and another), September 30, 1991 (30. 09. 91), (Family: none) | 1, 6, 7, 9 |

* Special categories of cited documents: ¹⁰

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| May 20, 1992 (20. 05. 92) | June 2, 1992 (02. 06. 92) |

| International Searching Authority | Signature of Authorized Officer |
|---|---|
| Japanese Patent Office | |

Form PCT/ISA/210 (second sheet) (January 1985)